# EUROPÄISCHE PATENTSCHRIFT

(11) **EP 2 955 531 B1**
(45) Veröffentlichungstag und Bekanntmachung des Hinweises auf die Patenterteilung: **06.11.2019**
(21) Anmeldenummer: 15166744.1
(22) Anmeldetag: 07.05.2015
(51) Int. Cl.: G01R 31/02

(54) **VERFAHREN UND VORRICHTUNG ZUR ÜBERWACHUNG EINER SCHUTZLEITERVERBINDUNG**
METHOD AND DEVICE FOR MONITORING A PROTECTIVE EARTH CONNECTION
PROCÉDÉ ET DISPOSITIF DESTINÉS À LA SURVEILLANCE D'UNE CONNEXION DE MISE À LA TERRE

(30) Priorität: 30.05.2014 DE 102014210290
(43) Veröffentlichungstag der Anmeldung: 16.12.2015
(73) Patentinhaber: Bender GmbH & Co. KG, 35305 Grünberg (DE)
(72) Erfinder: Häuslein, Bernd, 90411 Nürnberg (DE)
(74) Vertreter: advotec.

(56) Entgegenhaltungen:
- EP-A1- 0 010 861
- DE-A1- 2 416 784
- DE-A1-102007 059 365
- DE-B1- 2 843 094
- US-A1- 2013 307 555

## Beschreibung

Die Erfindung betrifft ein Verfahren zur Überwachung einer Schutzleiterverbindung einer elektrischen Zuleitung mit Überwachungsleiter, wobei sich die Zuleitung zwischen einer Einspeisestelle mit Erdungsanschluss und einem verbraucherseitigen Anschluss erstreckt, mit den Verfahrensschritten Erzeugen eines Prüfstroms und Einprägen des Prüfstroms an der Einspeisestelle zwischen dem Überwachungsleiter und dem Erdungsanschluss.

Weiterhin betrifft die Erfindung eine Vorrichtung zur Überwachung einer Schutzleiterverbindung einer elektrischen Zuleitung mit Überwachungsleiter, wobei sich die Zuleitung zwischen einer Einspeisestelle mit Erdungsanschluss und einem verbraucherseitigen Anschluss erstreckt, bestehend aus einem Prüfstrom-Generator zur Erzeugung eines Prüfstroms und einer Ankopplungsschaltung zur Einprägung des Prüfstroms an der Einspeisestelle zwischen dem Überwachungsleiter und dem Erdungsanschluss.

Bekannt ist aus der Auslegeschrift DE 28 43 094 B1 eine Schaltungsanordnung zur Überwachung eines Schutzleiters bei Hochspannungsleitungen im Bergbau. Dabei wird eine Rechteckwechselspannung an einen aus dem Schutzleiter und einem Überwachungsleiter gebildeten Überwachungsstromkreis angelegt. Der Überwachungsstromkreis ist verbraucherseitig mit einer Diode abgeschlossen, sodass ein gemessener Durchlassstrom ein Maß für den Schleifenwiderstand und ein gemessener Reststrom ein Maß für den Isolationswiderstand darstellt.

Die Offenlegungsschrift DE 24 16 784 A1 beschreibt einen Leitungswächter für ungeerdete Netze mit Schutzleiter und Überwachungsleiter. Der Leitungswächter weist neben einer Isolationsmesseinrichtung eine Spannungs-Überwachungsschaltung/Prüfvorrichtung auf, die eine Mess-Wechselspannung zwischen einen Schutzleiter und einen Überwachungsleiter einkoppelt. Die Überwachungsleitung ist mit einer Diode gegen Erde abgeschlossen, wobei im Fall der Unterbrechung des Überwachungskreises eine reine Wechselspannung an einem der Diode parallel geschalteten Widerstand abgreifbar ist.

In der Offenlegungsschrift DE 10 2007 059365 A1 ist eine elektronische Überwachungsschaltung zur Überwachung einer elektrischen Verbindung, vornehmlich von Versorgungsleitungen, zwischen elektrischen Geräten offenbart. Die Überwachungsschaltung weist eine Ansteuerungseinheit F für die Erzeugung eines Teststromimpulses zur Prüfung der Leitungsimpedanz sowie eine Auswerteeinheit G zur Auswertung eines Antwortsignals des Teststromimpulses auf.

Die Offenlegungsschrift US 2013/307555 A1 betrifft ein Testverfahren für ein elektrisches (Struktur-) Netzwerk in Flugzeugen, bei dem elektrisch leitfähige Elemente (Strukturen) des Flugzeugrumpfes zur Stromrückleitung verwendet werden. Die Impedanz einer elektrischen Struktur-Verbindungsstelle in dem Netzwerk wird durch Einkopplung eines Wechselstroms in einen parallel zu der Verbindungsstelle verlaufenden elektrischen Leiter bestimmt.

Weiterhin bekannt sind Schleifenüberwachungsgeräte zur Überwachung von Schleifenwiderständen bzw. Schutzleiterverbindungen. Derartige Geräte werden beispielsweise zur Erkennung einer Schutzleiterunterbrechung in elektrischen Anlagen eingesetzt. Dabei wird ein Überwachungsgerät mit Prüfstrom-Generator über eine Überwachungsleitung oder auch direkt an den geerdeten Körper eines elektrischen Verbrauchers einerseits und einen Erdungsanschluss andererseits angekoppelt. Der Stromkreis schließt sich über den Schutzleiter, so dass der in dem Überwachungsgerät messbare Strom eine Aussage über die Durchgängigkeit der Schutzleiterverbindung liefert. Unterschreitet der gemessene Strom - gleichbedeutend mit einer Überschreitung eines Schleifenwiderstands - einen voreingestellten Ansprechwert, so findet eine Alarmauslösung statt.

Ein Problem bei dieser Verfahrensweise stellen Mehrfacherdungen dar, die dann auftreten, wenn sich der Prüfstromkreis nicht nur über den Schutzleiter zurück zu dem Prüfstrom-Generator schließt, sondern zusätzlich parallele Strompfade existieren, die zu einer fehlerhaften Bewertung des Stromflusses führen können. Daneben treten Störeffekte, beispielsweise in Form von Ableitströmen auf, die den zu messenden Prüfstrom auf dem Schutzleiter überlagern und das Messergebnis verfälschen. An dem Beispiel eines Landanschlusses für Schiffe seien diese Probleme und deren erfindungsgemäße Lösung im Folgenden erläutert.

Es gibt Bestrebungen, bei der Be- und Entladung von Schiffen in Überseehäfen die elektrische Energieversorgung der Schiffe vom Land aus bereitzustellen. Dadurch können die schiffseigenen Aggregate stillgelegt werden, wodurch Kraftstoff gespart wird und die Schadstoffbelastung im Umfeld des Hafens für Umwelt und speziell auch Anwohner sinkt.

Bei einem derartigen Landanschluss muss gewährleistet sein, dass vor dem Zuschalten der Landeinspeisung und während der Stromversorgung von Land eine zuverlässige Schutzleiterverbindung zum Schiff besteht.

Mit den bekannten Schleifenüberwachungen ist in diesem Anwendungsfall eine zuverlässige Überwachung der Schutzleiterverbindung nicht gewährleistet, da diese Geräte parallel verlaufende Erdverbindungen, beispielsweise über das Salzwasser und die Landungsbrücken, nicht berücksichtigen und somit nicht erkennbar ist, ob sich die Prüfschleife tatsächlich nur über die vorgesehene Schutzleiterverbindung schließt. Eine fehlerhafte Freigabe der Einspeisespannung sowie eine während der Einspeisung unterbrochene Schutzleitung muss daher vermieden werden.

Selbst eine Messung des Stroms im Schutzleiter kann zu Fehlbewertungen führen, da oben beschriebene Störeffekte den tatsächlichen Prüfstrom überlagern und dessen sichere Detektion erschweren.

Der vorliegenden Erfindung liegt somit die Aufgabe zu Grunde, ein Verfahren und eine Vorrichtung zu entwickeln, die eine zuverlässige Überwachung einer Schutzleiterverbindung gewährleisten.

Diese Aufgabe wird bezogen auf ein Verfahren in Verbindung mit dem Oberbegriff des Anspruchs 1 dadurch gelöst, dass der eingeprägte Prüfstrom einen charakteristischen zeitlichen Verlauf aufweist, der eindeutig von betriebsmäßig auf dem Schutzleiter fließenden Strömen unterscheidbar ist, einspeiseseitig eine Messung des Schutzleiterstroms erfolgt und zur Erkennung einer Schutzleiterunterbrechung eine Auswertung des gemessenen Schutzleiterstroms durchgeführt wird.

Der Grundgedanke des vorliegenden Erfindung beruht zum einen darauf, dass der eingeprägte, durch das aktive Messverfahren erzeugte Prüfstrom einen von den übrigen auf dem Schutzleiter fließen Strömen deutlich unterscheidbaren Verlauf besitzt. Diese Stromsignatur ermöglicht eine klare Trennung des Prüfstromanteils in dem gemessenen Schutzleiterstrom.

Zum anderen findet auf der Einspeiseseite selektiv eine Strommessung in dem zu überwachenden Schutzleiter verbunden mit einer Auswertung des gemessenen Schutzleiterstroms statt. Dadurch wird festgestellt, ob die Schutzleiterverbindung tatsächlich die gewünschte Haupterdungsverbindung darstellt und ob nicht fälschlicherweise parallele Erdverbindungen eine nur scheinbar ordnungsgemäße Schutzleiterverbindung "vortäuschen".

In weiterer vorteilhafter Ausgestaltung wird der charakteristische zeitliche Verlauf des Prüfstroms aus einer Rechteck-Impulsfolge gebildet.

Die Rechteck-Impulsfolge unterscheidet sich dabei in ihrem zeitlichen Verlauf durch ihre Form und bei geeigneter Wahl von Impulsdauer und Impulsabstand auch hinsichtlich ihrer Grundfrequenz deutlich von den betriebsmäßig auf dem Schutzleiter fließenden Strömen und erlaubt damit eine fehlerfreie Ermittlung des Prüfstromanteils.

Bevorzugt wird der Prüfstromanteil in dem gemessenen Schutzleiterstrom ermittelt.

In diesem weiteren Verfahrensschritt wird der in dem gemessenen Schutzleiterstrom enthaltene Prüfstromanteil extrahiert. Diese Detektion kann durch geeignete analoge Filterschaltungen oder nach einer A/D-Umsetzung des Stromwertes mittels Filteralgorithmen auf digitaler Ebene geschehen. Da der Prüfstrom einen von den übrigen auf dem Schutzleiter fließen Strömen deutlich unterscheidbaren Verlauf aufweist, ist eine zuverlässige Detektion des Prüfstromanteils möglich.

Die Größe des ermittelten Prüfstromanteils liefert eine Aussage über das Bestehen einer ordnungsgemäßen Schutzleiterverbindung.

In weiterer Ausgestaltung wird der gemessene Schutzleiterstrom mit dem zeitlichen Verlauf des eingeprägten Prüfstroms synchronisiert.

Die Synchronisation des gemessenen Schutzleiterstroms auf den von dem Prüfstrom-Generator erzeugten Prüfstrom erleichtert die Detektion des in dem gemessenen Schutzleiterstrom enthaltenen Prüfstromanteils.

Vorteilhafterweise erfolgt bei Unterschreitung eines einstellbaren Prüfstrom-Ansprechwertes durch den ermittelten Prüfstromanteil eine Alarmmeldung.

Wird bei der Auswertung des gemessenen Schutzleiterstroms festgestellt, dass der ermittelte Prüfstromanteil unterhalb eines Prüfstrom-Ansprechwertes, also einer vorgebbaren Auslöseschwelle liegt, so deutet dies auf eine Schutzleiterunterbrechung hin und eine Alarmmeldung wird ausgegeben.

In vorteilhafter Weise findet das vorbeschriebene Verfahren Anwendung in Verbindung mit einer Überwachung des Schutzleiters bei einem Landanschluss für Schiffe.

Insbesondere im Zuge einer weltweiten Standardisierung des Landanschlusses von Schiffen gewinnt eine zuverlässige Schutzleiterverbindung der elektrischen Zuleitung bei der Landeinspeisung zunehmend an Bedeutung.

Die vorliegende Erfindung ist allerdings nicht auf diesen Anwendungsfall beschränkt. Weitere vorteilhafte Anwendungsfälle bestehen überall dort, wo parallele Mehrfacherdungen zu einer fehlerhaften Interpretation des Stromflusses an einem Erdungsanschluss führen können und dort, wo Störströme das Messergebnis auf dem Schutzleiter selbst verfälschen.

Bezogen auf eine Vorrichtung wird die Aufgabe in Verbindung mit dem Oberbegriff des Anspruchs 7 dadurch gelöst, dass die Überwachungsvorrichtung eine Anschlussvorrichtung zum Anschluss mindestens eines Messstromwandlers und eine Auswerteeinrichtung zur Erkennung einer Schutzleiterunterbrechung auf Basis eines mit dem Messstromwandler gemessenen Stromes aufweist.

Da die beanspruchte Überwachungsvorrichtung eine Realisierung des oben beanspruchten Verfahrens zur Überwachung einer Schutzleiterverbindung darstellt, treffen die für das Verfahren aufgeführten vorteilhaften Wirkungen gleichermaßen auf die erfindungsgemäße Überwachungsvorrichtung zu.

Insbesondere weist die Überwachungsvorrichtung eine Anschlussvorrichtung für den Anschluss mindestens eines Messstromwandlers auf. Diese Ausgestaltung ermöglicht eine Erfassung des Stromes unmittelbar auf dem Schutzleiter, um daraus unter Nutzung der deutlich unterscheidbaren Stromsignatur des Prüfstromes einen Prüfstromanteil extrahieren zu können.

In einer Auswerteeinrichtung kann auf der Grundlage des von dem Messstromwandler erfassten Schutzleiterstroms und des aus diesem extrahierten Prüfstromanteils eine Aussage über den elektrischen Zustand der Schutzleiterverbindung getroffen werden.

Um den Prüfstromanteil von den auf dem Schutzleiter vorhandenen Störströmen zu trennen, kann die Auswerteeinrichtung eine Filtereinheit umfassen. Diese kann als analoge Filterschaltung oder in Verbindung mit einer A/D-Umsetzung des erfassten Schutzleiterstroms als digitales Filter ausgebildet sein.

Weiterhin kann die Überwachungsvorrichtung einen Entscheider zur Erkennung einer Unterschreitung eines einstellbaren Prüfstrom-Ansprechwertes durch den ermittelten Prüfstromanteil und zur Ausgabe einer Alarmmeldung umfassen. In dem Entscheider wird festgelegt, wann eine Schutzleiterverbindung als unterbrochen oder schadhaft gilt und demzufolge eine Alarmmeldung ausgegeben werden soll. Als Entscheidungskriterium dient ein einstellbarer Prüfstrom-Ansprechwert, bei dessen Unterschreitung der Alarm ausgelöst wird.

Weiterhin umfasst die Überwachungseinrichtung eine Synchronisationseinrichtung zur Synchronisation des gemessenen Schutzleiterstroms mit dem zeitlichen Verlauf des eingeprägten Prüfstroms.

Die Synchronisationseinrichtung stellt die zeitliche Beziehung zwischen dem gemessenen Schutzleiterstrom und dem eingeprägten Prüfstrom her, so dass die Erkennung des Prüfstromanteils in dem mit Störsignalen behafteten Schutzleiterstrom sicher durchgeführt werden kann.

Weitere vorteilhafte Ausgestaltungsmerkmale ergeben sich aus der nachfolgenden Beschreibung und der Zeichnung, die eine bevorzugte Ausführungsform der Erfindung an Hand eines Beispiels erläutert. Es zeigt die:

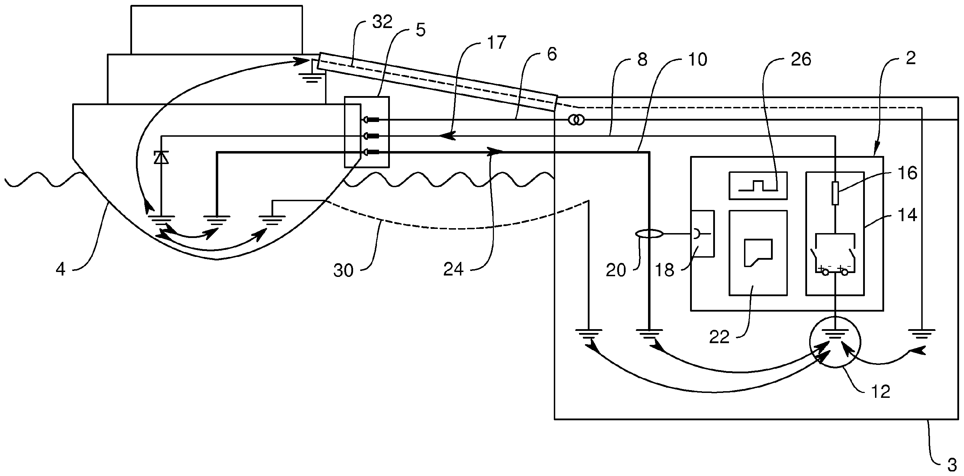

- **Fig. 1:**: ein erfindungsgemäßes Überwachungsgerät in Verbindung mit einem Landanschluss von Schiffen.

Die **Fig. 1** zeigt in schematischer Darstellung am Beispiel eines Landanschlusses für Schiffe 4 eine Anwendung für das erfindungsgemäße Verfahren mit einer Ausführung der das Verfahren umsetzenden Überwachungsvorrichtung 2.

Das Schiff 4 ist über einen verbraucherseitigen Anschluss 5 und eine elektrische Zuleitung 6 zur Hauptstromversorgung mit einer Einspeisestelle 3 verbunden. Der verbraucherseitige Anschluss 5 umfasst weiterhin einen Überwachungsleiter 8 und einen Schutzleiter 10 (Schutzleiterverbindung). Die Einspeisestelle 3 ist mit einem Erdungsanschluss 12 versehen.

Die an der Einspeisestelle 3 angeordnete Überwachungseinrichtung 2 besteht aus einem Prüfstrom-Generator 14 zur Erzeugung eines Prüfstroms 17, einer Ankopplungsschaltung 16 zur Einprägung des Prüfstroms 17 in den Überwachungsleiter 8, einer Anschlussvorrichtung 18 für den Anschluss eines Messstromwandlers 20 zur Strommessung auf dem Schutzleiter 10, einer Auswerteeinrichtung 22 zur Auswertung des erfassten Schutzleiterstroms 24 und einer Synchronisationseinrichtung 26 zur Synchronisation des gemessenen Schutzleiterstroms 24 mit dem zeitlichen Verlauf des eingeprägten Prüfstroms 17.

In dem dargestellten beispielhaften Anwendungsfall des Landanschlusses von Schiffen kann der an der Einspeisestelle 3 in den Überwachungsleiter 8 eingeprägte Prüfstrom 17 mehrere unbestimmte Wege zurück zum Prüfstrom-Generator 14 nehmen. Der Prüfstromkreis kann sich beispielsweise über das elektrisch leitfähige Salzwasser 30 oder über eine Landungsbrücke 32 schließen. Würde nun der Prüfstrom nur zentral in dem Überwachungsgerät 2 gemessen werden, so würde infolge der zu dem Schutzleiter 10 parallel verlaufenden Stromwege über das Salzwasser 30 und die Landungsbrücke 32 ein Stromfluss gemessen werden, obwohl unter Umständen der Schutzleiter 10 unterbrochen wäre. Um diese Fehlinterpretation zu vermeiden, erfolgt erfindungsgemäß einspeiseseitig eine gezielte Messung des Schutzleiterstroms 24 mit einem Messstromwandler 20.

Da auch der Schutzleiterstrom 24 durch Störeffekte, die vorrangig ihre Ursache in betriebsmäßig fließenden Ableitströmen haben, überlagert ist, würde beispielsweise ein reiner 50/60 Hz-Wechselstrom als Prüfstrom 17 in dem erfassten Schutzleiterstrom 24 schwer extrahierbar sein. Daher weist der Prüfstrom 17 erfindungsgemäß einen charakteristischen zeitlichen Verlauf auf, der ihn eindeutig von betriebsmäßig auf dem Schutzleiter 10 fließenden Strömen unterscheidbar macht.

Auf Grund dieser Stromsignatur kann der Prüfstromanteil dann in der Auswerteeinrichtung 22 einfacher herausgefiltert und anschließend bewertet werden.

Zur weiteren Unterstützung der Auswertung besitzt die Überwachungsvorrichtung eine Synchronisationseinrichtung 26, die den gemessenen Schutzleiterstrom 24auf eingeprägten Prüfstrom 17 synchronisiert.

## Patentansprüche

1. Verfahren zur Überwachung einer Schutzleiterverbindung (10) einer elektrischen Zuleitung (6) mit Überwachungsleiter (8), wobei sich die Zuleitung (6) zwischen einer Einspeisestelle (3) mit Erdungsanschluss (12) und einem verbraucherseitigen Anschluss (5) erstreckt, umfassend die Verfahrensschritte:
- Erzeugen eines Prüfstroms (17),
- Einprägen des Prüfstroms (17) an der Einspeisestelle (3) zwischen dem Überwachungsleiter (8) und dem Erdungsanschluss (12),
**dadurch gekennzeichnet, dass**
- der eingeprägte Prüfstrom (17) einen charakteristischen zeitlichen Verlauf aufweist, der eindeutig von betriebsmäßig auf dem Schutzleiter (10) fließenden Strömen unterscheidbar ist,
- einspeiseseitig eine Messung des Schutzleiterstroms (24) erfolgt, und
- zur Erkennung einer Schutzleiterunterbrechung eine Auswertung des gemessenen Schutzleiterstroms (24) durchgeführt wird.

2. Verfahren nach Anspruch 1,
**dadurch gekennzeichnet,**
**dass** der charakteristische zeitliche Verlauf des Prüfstroms (17) aus einer Rechteck-Impulsfolge gebildet wird.

3. Verfahren nach Anspruch 1 oder 2,
**dadurch gekennzeichnet,**
**dass** ein Prüfstromanteil in dem gemessenen Schutzleiterstrom (24) ermittelt wird.

4. Verfahren nach einem der Ansprüche 1 bis 3,
**dadurch gekennzeichnet,**
**dass** der gemessene Schutzleiterstrom (24) mit dem zeitlichen Verlauf des eingeprägten Prüfstroms (17) synchronisiert wird.

5. Verfahren nach Anspruch 3 oder 4,
**dadurch gekennzeichnet,**
**dass** bei Unterschreitung eines einstellbaren Prüfstrom-Ansprechwertes durch den ermittelten Prüfstromanteil eine Alarmmeldung erfolgt.

6. Verfahren nach einem der Ansprüche 1 bis 5,
**gekennzeichnet durch**
die Anwendung in Verbindung mit einer Überwachung des Schutzleiters bei einem Landanschluss für Schiffe (4).

7. Vorrichtung zur Überwachung einer Schutzleiterverbindung (10) einer elektrischen Zuleitung (6) mit Überwachungsleiter (8), wobei sich die Zuleitung (6) zwischen einer Einspeisestelle (3) mit Erdungsanschluss (12) und einem verbraucherseitigen Anschluss (5) erstreckt, bestehend aus einem Prüfstrom-Generator (14) zur Erzeugung eines Prüfstroms (17) und einer Ankopplungsschaltung (16) zur Einprägung des Prüfstroms (17) an der Einspeisestelle (3) zwischen dem Überwachungsleiter (8) und dem Erdungsanschluss (12),
**gekennzeichnet durch**
eine Anschlussvorrichtung (18) für den Anschluss mindestens eines Messstromwandlers (20) und eine Auswerteeinrichtung (22) zur Erkennung einer Schutzleiterunterbrechung auf Basis eines mit dem Messstromwandler (20) gemessenen Stromes (24).

8. Überwachungsvorrichtung nach Anspruch 5 oder 6,
**gekennzeichnet durch**
eine Synchronisationseinrichtung (26) zur Synchronisation des gemessenen Schutzleiterstroms (24) mit dem zeitlichen Verlauf des eingeprägten Prüfstroms (17).

## Claims

1. A method for monitoring a protective ground connection (10) of an electrical feeder (6) using a monitoring conductor (8), the feeder (6) extending between a feeding point (3) having a grounding connection (12) and a load-side connection (5), comprising the method steps of:
- generating a test current (17),
- injecting the test current (17) at the feeding point (3) between the monitoring conductor (8) and the grounding connection (12),
**characterized in that**
- the injected test current (17) has a characteristic temporal progression that can be clearly distinguished from currents running on the protective ground (10) during operation,
- the protective ground current (24) is measured at the feeding side, and
- the measured protective ground current (24) is evaluated so as to detect an interruption of the protective ground.

2. The method according to claim 1,
**characterized in that**
the characteristic temporal progression of the test current (17) is formed by a rectangular pulse train.

3. The method according to claim 1 or 2,
**characterized in that**
a test current portion in the measured protective ground current (24) is determined.

4. The method according to any of the claims 1 to 3,
**characterized in that**
the measured protective ground current (24) is synchronized with the temporal progression of the injected test current (17).

5. The method according to claim 3 or 4,
**characterized in that**
an alarm is triggered if the determined test current portion falls short of an adjustable test current response value.

6. The method according to any of the claims 1 to 5,
**characterized by**
being implemented in connection with the monitoring of the protective ground in a shore connection for ships (4).

7. A device for monitoring a protective ground connection (10) of an electrical feeder (6) using a monitoring conductor (8), the feeder (6) extending between a feeding point (3) having a grounding connection (12) and a load-side connection (5), consisting of a test current generator (14) for generating a test current (17) and a coupling circuit (16) for injecting the test current (17) at the feeding point (3) between the monitoring conductor (8) and the grounding connection (12),
**characterized by**
a connection device (18) for connecting at least one measuring current transformer (20) and by an evaluating device (22) for detecting an interruption of the protective ground on the basis of a current (24) measured with the measuring current transformer (20).

8. The monitoring device according to claim 7,
**characterized by**
a synchronization device (26) for synchronizing the measured protective ground current (24) with the temporal progression of the injected test current (17).

## Revendications

1. Procédé de surveillance d'une connexion d'un conducteur de protection (10) d'un fil d'amenée (6) électrique en utilisant un conducteur de surveillance (8), le fil d'amenée (6) s'étendant entre un point d'injection (3) ayant une prise de terre (12) et un connexion (5) du côté du consommateur, le procédé comprenant les étapes consistant à :
- générer un courant de test (17),
- injecter le courant de test (17) au point d'injection (3) entre le conducteur de surveillance (8) et la prise de terre (12),
**caractérisé en ce que**
- le courant de test (17) injecté à une évolution temporelle caractéristique qui peut être clairement distinguée de courants traversant le conducteur de protection (10) lors du fonctionnement,
- le courant (24) du conducteur de protection est mesuré du côté de l'injection, et
- le courant (24) mesuré du conducteur de protection est évalué afin de détecter une coupure du conducteur de protection.

2. Procédé selon la revendication 1,
**caractérisé en ce que**
l'évolution temporelle caractéristique du courant de test (17) est formée par une répétition d'impulsions carrées.

3. Procédé selon la revendication 1 ou 2,
**caractérisé en ce**
**qu'**une partie de courant de test dans le courant (24) mesuré du conducteur de protection est déterminée.

4. Procédé selon l'une quelconque des revendications 1 à 3,
**caractérisé en ce que**
le courant (24) mesuré du conducteur de protection est synchronisé avec l'évolution temporelle du courant de test (17) injecté.

5. Procédé selon la revendication 3 ou 4,
**caractérisé en ce**
**qu'**une alarme est déclenchée si la partie de courant de test déterminée n'atteint pas une valeur de réponse de courant de test réglable.

6. Procédé selon l'une quelconque des revendications 1 à 5,
**caractérisé en ce**
**qu'**il s'applique à la surveillance du conducteur de protection dans un prise de quai pour des bateaux (4).

7. Dispositif de surveillance d'une connexion d'un conducteur de protection (10) d'un fil d'amenée (6) utilisant un conducteur de surveillance (8), le fil d'amenée (6) s'étendant entre un point d'injection (3) ayant une prise de terre (12) et une connexion (5) du côté du consommateur, se composant d'un générateur (14) de courant de test destiné à générer un courant de test (17) et d'un circuit de couplage (16) pour l'injection du courant de test (17) au point d'injection (3) entre le conducteur de surveillance (8) et la prise de terre (12),
**caractérisé par**
un dispositif de connexion (18) pour la connexion d'au moins un transformateur (20) de courant de mesure et par un dispositif d'évaluation (22) destiné à détecter une coupure du conducteur de protection sur la base d'un courant (24) mesuré par le transformateur (20) de courant de mesure.

8. Dispositif de surveillance selon la revendication 7,
**caractérisé par**
un dispositif de synchronisation (26) destiné à synchroniser le courant (24) mesuré du conducteur de protection avec l'évolution temporelle du courant de test (17) injecté.
